# EUROPEAN PATENT APPLICATION

(11) **EP 1 071 215 A1**
(43) Date of publication of application: **24.01.2001**
(21) Application number: 99830457.0
(22) Date of filing: 19.07.1999
(51) Int. Cl.: H03K 19/00, H03K 19/017

(54) **Input stage with dynamic hysteresis**

(71) Applicant: STMicroelectronics S.r.l., 20041 Agrate Brianza (Milano) (IT)
(72) Inventor: Fucili, Giona, 20129 Milano (IT)
(74) Representative: Pellegri, Alberto

(57) **Abstract**

A circuit for shifting the triggering threshold of a stage (MP1,MN1) having an input coupled to a circuital node (OUT), following the sensing of a switching phase of said node from a logic state to another and for the remaining duration of the switching phase, produces a hysteresis effectively greater than the maximum theoretical limit of hysteresis admitted by the triggering threshold of the stage (MP1,MN1) coupled to said circuital node. The circuit comprises at least two switches, a first switch (MP2) connected in an electric path between said circuital node (OUT) and a supply rail (Vdd) and the second switch (MN2) connected in an electric path between said circuital node (OUT) and ground; at least a generator (P1,P2) of a single pulse of duration equal or longer than the duration of the rise time and of the fall time of the voltage on said circuital node, and shorter than the minimum time of persistence at a certain logic state of said circuital node (OUT), having an input coupled to said circuital node (OUT) and generating said single pulse upon sensing a switching from a logic state to another of said circuital node. Means coupled to an output of said pulse generator and to the control nodes of said switches configure the switches (MP2,MN2) in a state such to maintain the new logic state assumed by said circuital node (OUT) for the duration of said single pulse.

## Description

### FIELD OF THE INVENTION

The present invention relates in general to digital circuits and in particular, although not exclusively, to CMOS circuits.

### BACKGROUND OF THE INVENTION

Decreasing the supply voltage of CMOS circuits from 5V to 3.3V or even to lower voltages imposes the use of input circuits with increasingly closer triggering thresholds.

Hence, the maximum hysteresis that may be defined, becomes progressively limited and thereby immunity to noise is reduced accordingly. Disturbances become critical particularly during switchings.

### PURPOSE AND SUMMARY OF THE INVENTION

The response characteristics of an input circuit are often relatively faster than the transitions from a logic state to another of the circuital node to which the input of the circuit is coupled.

Therefore, an input stage with a dynamic hysteresis would be very useful, that is an input stage with a hysteresis that is as wide as possible during the transition phases or switchings, practically well beyond the constraints of definition of a maximum tolerable hysteresis derived from the definition of the triggering threshold of circuits operating at increasingly lower supply voltage.

This important result is obtained according to the present invention by a circuit that shifts the triggering threshold of a generic input stage, constituted by at least two switches, a first switch being connected in an electric path between said circuital node and the supply voltage and the second switch being connected in an electric path between said circuital node and ground.

A one-shot generator of a single pulse of equal or greater duration than the duration of the rising and falling edges of the voltage on said circuital node and smaller than the minimum time of persistence at a certain logic state of said circuital node, has an input coupled to said circuital node and outputs a single pulse upon sensing a switching from a logic state to another of said circuital node to which the input stage is coupled.

Circuit means coupled to the output of the one-shot pulse generator and to the control nodes of the two switches configure the switches in a way to maintain the new logic state, assumed upon sensing the switching of said circuital node, for the entire pre-established duration of the pulse.

### BRIEF DESCRIPTION OF FIGURES

**Figure 1** represents a basic scheme of the threshold shifting circuit of the invention.

**Figure 2** shows a different application of the invention.

**Figure 3** shows the basic scheme of an embodiment of the circuit of the invention using one-shot pulse generator.

**Figure 4** shows the diagram of a pulse generator suitable for use in the circuit of the invention.

**Figure 5** shows another application to one Schmitt-trigger input stage.

**Figures 6** and **7** show two alternative embodiments of an input buffer for ensuring haloes-free outputs.

**Figure 8** illustrates the behavior of a circuit with standard hysteresis as compared to a circuit with a dynamic hysteresis according to the present invention.

### DESCRIPTION OF SEVERAL EMBODIMENTS

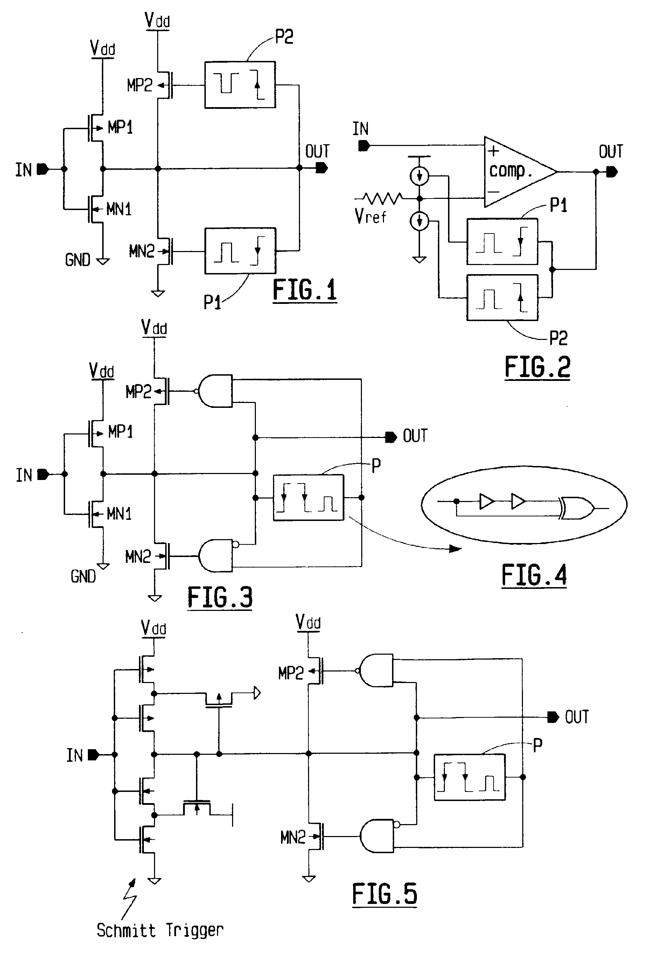

By referring to the basic scheme of figure 1, let us suppose to size MN1 and MP1 such to realize a standard inverter, that is, without hysteresis and with a triggering threshold exactly half the value of the supply voltage Vdd and let us also assume that the input voltage IN rise from 0V to the threshold value Vdd/2.

As soon as the inverter switches, the pulse generator P1 generates a pulse that turns MN2 on. Because MN2 is electrically in parallel to MN1, the triggering threshold that has just been surpassed, decreases significantly if MN2 is considerably more conductive than MN1 (at the limit the output OUT may result short-circuited to ground through MN2).

The duration of the pulse generated by P1 must be sufficiently long to allow for the input signals to undergo a complete transition, but it should terminate before the occurrence of a successive falling edge of the digital input signal (IN).

As far as the falling edges are concerned, they are subject to the same considerations made for the rising edges in a perfectly dual manner, though in this case reference must be made to the MP1 and MP2 transistors and to the pulse generator P2.

In practice, if MN2 and MP2 are highly conductive (very wide channel) in respect to MP1 and MN1, a "virtual" hysteresis that is practically equal to the supply voltage is achieved.

The same concept of "dynamic" hysteresis just described, implemented through the pair of switches MP2 and MN2 and by the pulse generators P1 and P2 in the example of Fig. 1, applies also to alternative solutions different from those of a CMOS input stage (indicated by way of example in the form of a common inverter), as schematically indicated in Fig. 2.

In this case the intrinsic threshold Vref of a comparator may be altered by injecting a current of an appropriate value and direction through the series resistance or in any other equivalent fashion, provided that the pulse generators that introduce the desired dynamic character of the hysteresis are employed.

In practice, especially if the rising edges and the falling edges of the input signal have a substantially equal duration, it may be sufficient to employ only one pulse generator, as indicated in Fig. 3.

Figure 4 shows a very simple CMOS circuit capable of generating a pulse at each transition of its input. The pulse duration is given by the delay of the inverter chain.

It is possible also to employ the threshold shifting circuit of the invention for implementing a standard "Schmitt trigger" instead of an input inverter, as indicated in Fig. 5.

The circuits of figures 1, 3 and 5 are all inverting. However, as evident to the skilled person, a non-inverting structure may be obtained by adding to the input circuit, which includes the threshold shifting circuit of the invention, a common inverter before the output.

The use of an input stage with a dynamic hysteresis according to the invention is particularly appropriate for signals that undergo a relatively "slow" variation compared to the response characteristic of the input stage itself.

For example, an input stage for synchronous networks realized according to the invention is particularly appropriate for the timing signal (clock), because any double switchings caused by noise could have disastrous effects.

By contrast, it is not necessary and at times inconvenient to introduce the threshold shifting circuit of the invention in case of signals to be sampled by the clock signal. In fact, the dynamic hysteresis that is introduced may slow down the return to a steady state in the event of a noise "spike" while the signal is not changing.

Since the clock allows for the information to be read only during its switchings (generally at the rising or at the falling edge), it is advisable that the effects of eventual changes of the signals to be sampled due to noise decay in the shortest possible time (before the clock working edge that reads the signals).

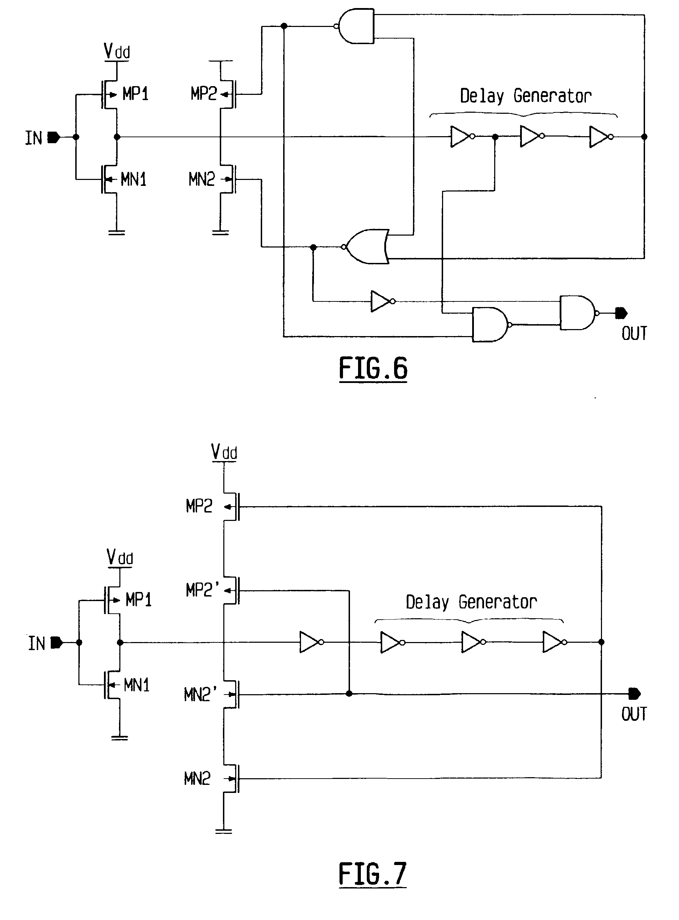

Figures 6 and 7 indicate two alternative embodiments of an input stage with dynamic hysteresis according to the present invention. In this case the output of the circuit changes only when the dynamic hysteresis has been activated. In fact, the output depends directly on the same signals that switches the transistors MP2 and MN2 which in turn produce the hysteresis.

This alternative embodiment is useful when there exists a need to safeguard the output of the circuit from "haloes" (a phenomenon due to signal propagation on paths with not equalized delay characteristics).

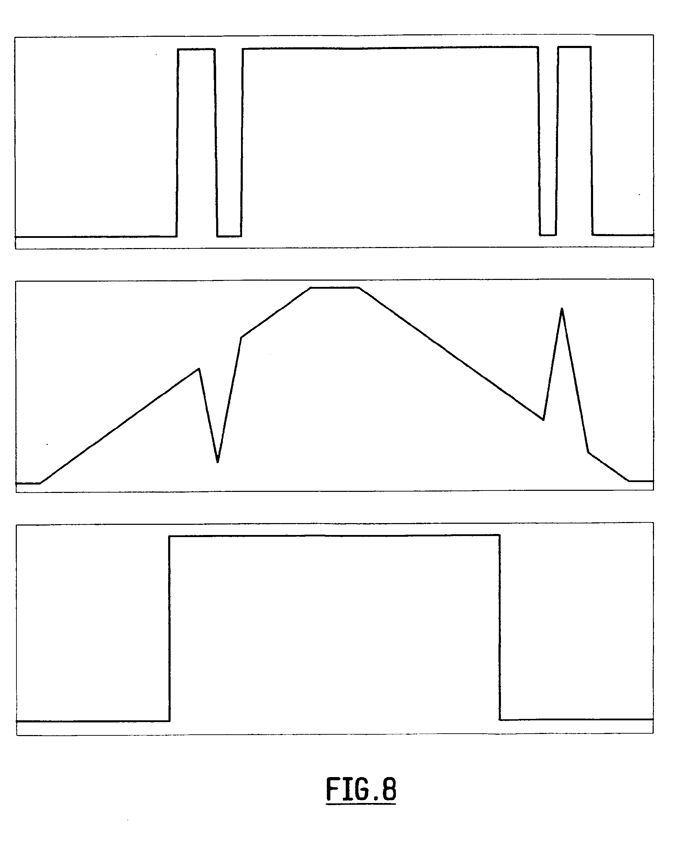

Figure 8 illustrates the different behavior of a normal input buffer stage with hysteresis (first waveform) and of one with dynamic hysteresis according to the present invention (third waveform).

The input signal common to both circuits, represented by the second waveform, switches with rise and fall times of 50ns, and on both rising and falling edges there are very ample disturbances (around 2/3 of the supply voltage) and of remarkable duration (more than 5-10 times the switching time of the circuit itself).

As it may be noticed, a normal circuit (first waveform) tracks the noise and undergoes spurious switchings, while the circuit of the invention (second waveform) rejects the noise completely.

## Claims

1. A circuit for shifting the triggering threshold of a stage having an input coupled to a circuital node, following the sensing of a switching phase of said node from a logic state to another and for the remaining duration of the switching phase, producing a hysteresis effectively greater than the maximum theoretical limit of hysteresis admitted by the triggering threshold of the stage coupled to said circuital node, comprising
at least two switches, a first switch connected in an electric path between said circuital node and a supply rail and the second switch connected in an electric path between said circuital node and ground;
at least a generator of a single pulse of duration equal or longer than the duration of the rise time and of the fall time of the voltage on said circuital node, and shorter than the minimum time of persistence at a certain logic state of said circuital node, having an input coupled to said circuital node and generating said single pulse upon sensing a switching from a logic state to another of said circuital node;
means coupled to an output of said pulse generator and to the control nodes of said switches configuring the switches in a state for maintaining the new logic state assumed by said circuital node for the duration of said single pulse.

2. The circuit of claim 1, characterized in that said generator is a monostable circuit.

3. The circuit of claim 1, characterized in that said stage coupled to said circuital node is a CMOS inverter and said switches are CMOS devices having an internal resistance in conduction lower than the internal resistance of the respective devices that compose the CMOS inverter.

4. The circuit of claim 1, characterized in that the switches are replaced with circuital elements capable of modifying a reference voltage.
